(19) Europäisches Patentamt / European Patent Office / Office européen des brevets

(11) **EP 3 584 514 B1**

(12) **FASCICULE DE BREVET EUROPEEN**

(45) Date de publication et mention de la délivrance du brevet:
**27.11.2024 Bulletin 2024/48**

(21) Numéro de dépôt: **19169382.9**

(22) Date de dépôt: **16.04.2019**

(51) Classification Internationale des Brevets (IPC):
**F25B 5/04** *(2006.01)*    **F25B 49/02** *(2006.01)*
**H05K 7/20** *(2006.01)*

(52) Classification Coopérative des Brevets (CPC):
**F25B 49/02; F25B 5/04; H05K 7/20681;**
F25B 2500/19; F25B 2600/2501; F25B 2600/2511;
H02B 1/56

(54) **PROCEDE DE COMMANDE D'UNE INSTALLATION DE REFROIDISSEMENT ASSOCIEE A UNE ARMOIRE ELECTRIQUE**

STEUERVERFAHREN EINER MIT EINEM ELEKTRISCHEN SCHALTSCHRANK VERBUNDENEN KÜHLANLAGE

METHOD FOR CONTROLLING A COOLING SYSTEM ASSOCIATED WITH AN ELECTRICAL CABINET

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.06.2018 FR 1855327**

(43) Date de publication de la demande:
**25.12.2019 Bulletin 2019/52**

(73) Titulaire: **Schneider Electric Industries SAS
92500 Rueil Malmaison (FR)**

(72) Inventeurs:
• LOPEZ, Josep
  **38050 Grenoble (FR)**
• PERRIN, Alain
  **38050 Grenoble (FR)**

(74) Mandataire: **Schneider Electric
Service Propriété Industrielle
160 Avenue des Martyrs
38000 Grenoble (FR)**

(56) Documents cités:
**EP-A1- 2 759 786     FR-A1- 2 971 041
US-A1- 2013 263 611**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**Domaine technique de l'invention**

La présente invention se rapporte à un procédé de commande d'une installation de refroidissement employé pour refroidir le volume interne d'une enveloppe électrique, telle que par exemple une armoire électrique. L'invention concerne également l'installation de refroidissement dans laquelle est mise en oeuvre ledit procédé.

**Etat de la technique**

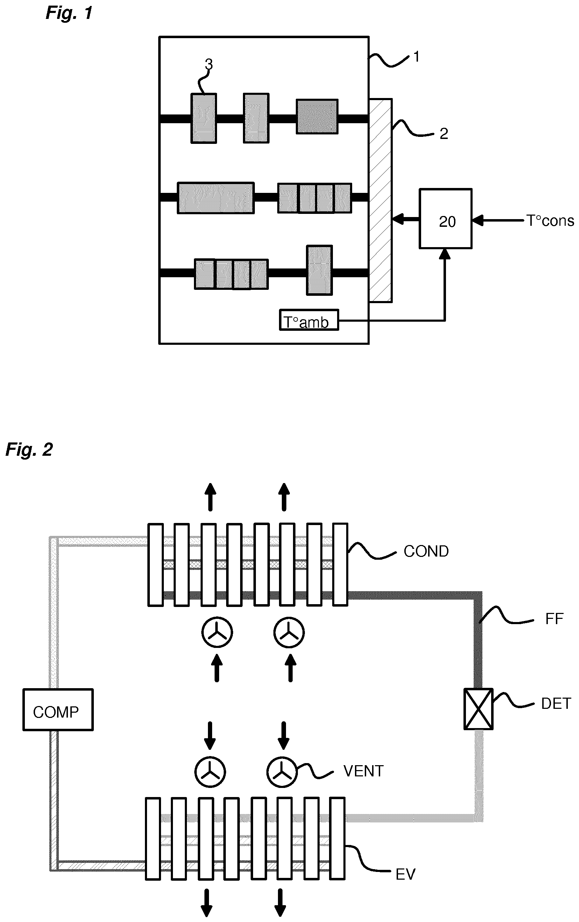

De manière connue, en référence à la figure 1, une armoire électrique 1 renferme des appareils électriques 3, certains dégageant de la chaleur pendant leur fonctionnement. Une armoire électrique 1 peut donc être dotée d'une installation de refroidissement 2 pour refroidir son volume interne et dégager la chaleur vers l'extérieur. L'installation de refroidissement 2 peut notamment intégrer un climatiseur permettant de refroidir l'air à l'intérieur de l'armoire et d'évacuer l'air chaud vers l'extérieur.

De manière connue, en référence à la figure 2, un climatiseur est une machine thermodynamique à faire du froid. Il se compose essentiellement de deux échangeurs thermiques (un évaporateur EV et un condenseur COND) associés à un compresseur COMP. Le tout fonctionne en circuit fermé et étanche, où circule un fluide frigorigène FF rendu alternativement liquide ou gazeux.

L'air présent à l'intérieur de l'armoire électrique 1 est puisé et refroidi dans l'évaporateur EV, au contact du fluide frigorigène FF rendu gazeux, avant d'être rediffusé dans le volume interne de l'armoire 1. Le fluide frigorigène FF poursuit son chemin sous forme de vapeur jusqu'au compresseur COMP, qui le comprime en l'échauffant (haute pression) puis l'envoie au condenseur COND. Ce dernier extrait les calories dues à l'échauffement et les évacue hors de l'armoire électrique. Dans le même temps, le fluide redevenu liquide (basse pression) est redirigé vers l'évaporateur EV en passant par un détendeur DET. Cette alternance de phases se répète en boucle jusqu'à l'obtention de la température désirée. Les échanges thermiques peuvent être accélérés par un dispositif de ventilation et régulés électroniquement. En simplifiant, l'automate programmable 20 de l'installation reçoit une valeur de consigne T°cons et exécute une boucle de régulation de température à partir de la température T°amb mesurée à l'intérieur de l'armoire électrique 1.

Les composants d'une telle installation de refroidissement, notamment le compresseur, sont dimensionnés par rapport à une puissance thermique maximale à dissiper (exprimées en Watt) que les appareils électriques 3 présents dans l'armoire électrique peuvent générer. Or il s'avère que cette puissance thermique maximale n'est pas toujours atteinte ou alors pas en permanence. Le compresseur COMP de l'installation de refroidissement se trouve alors être très souvent surdimensionné par rapport aux besoins réels de refroidissement du volume interne de l'armoire électrique et la puissance qu'il produit en surplus se trouve alors être définitivement perdue. Z

US 2013/263611 A1 divulgue un dispositif de contrôle automatisé pour un système de refroidissement refroidissant au moins un composant électronique. Le dispositif de contrôle comprend la surveillance de la variation d'une variable opérationnelle du système de refroidissement ou d'au moins un composant refroidi par le système de refroidissement et, sur la base de la variation de la variable opérationnelle sur une période donnée, la détermination de l'ajustement de la commande du système de refroidissement pour limiter la variation de la variable opérationnelle.

Le but de l'invention est de proposer une solution permettant d'éviter tout surdimensionnement de l'installation de refroidissement et d'éviter toute perte d'énergie lorsque la puissance thermique à dissiper n'est pas maximale.

**Exposé de l'invention**

Ce but est atteint par un procédé de commande d'une installation de refroidissement du volume interne d'une enveloppe électrique selon la revendication 1.

Selon une autre particularité, la puissance thermique à dissiper est déterminée à partir de la différence entre une valeur de température de consigne et une valeur de température présente dans le volume interne de l'enveloppe électrique.

Selon une autre particularité, la puissance thermique que le premier évaporateur est capable de dissiper est déterminée lors du dimensionnement de l'installation puis paramétré dans l'automate programmable.

L'invention concerne également une installation de refroidissement du volume interne d'une enveloppe électrique selon la revendication 4.

Selon une particularité, les moyens de commutation comportent une vanne trois voies aptes à prendre au moins deux états, un premier état dans lequel le circuit de refroidissement secondaire est connecté au circuit de refroidissement primaire (C1) dans le premier mode de fonctionnement, et un deuxième état dans lequel le circuit de refroidissement secondaire est déconnecté du circuit de refroidissement primaire dans le deuxième mode de fonctionnement.

Selon une autre particularité, le premier évaporateur est de type hybride comportant deux circuits de refroidissement indépendants, un premier circuit de refroidissement appartenant au circuit de refroidissement primaire et un deuxième circuit de refroidissement relié au circuit de refroidissement secondaire par l'intermédiaire d'une pompe incluse dans lesdits moyens de commutation.

Selon une autre particularité, la puissance thermique à dissiper est déterminée à partir de la différence entre une valeur de température de consigne et une valeur de température présente dans le volume interne de l'enveloppe électrique.

Selon une autre particularité, le dimensionnement en puissance thermique à dissiper du deuxième évaporateur est supérieur à celui du compresseur.

Selon une autre particularité, la puissance thermique que le premier évaporateur est capable de dissiper est déterminée lors du dimensionnement puis paramétré dans l'automate programmable.

**Brève description des figures**

D'autres caractéristiques et avantages vont apparaître dans la description détaillée qui suit, en liaison avec les figures annexées listées ci-dessous :

- La figure 1 représente de manière schématique une armoire électrique à laquelle est associée une installation de refroidissement ;
- La figure 2 représente de manière schématique une installation de refroidissement telle que connue dans l'état de la technique ;
- Les figures 3A et 3B représentent de manière schématique, deux modes de réalisation distincts de l'installation de refroidissement de l'invention ;
- La figure 4 représente un diagramme illustrant l'algorithme mis en oeuvre pour le fonctionnement d'une installation de refroidissement conforme à l'invention ;
- Les figures 5A et 5B illustrent le fonctionnement d'une installation de refroidissement conforme à l'invention, respectivement lorsque le premier mode de fonctionnement est actif et lorsque le deuxième mode de fonctionnement est actif ;

Les références utilisées sur les figures annexées restent identiques d'une figure à l'autre, dans la mesure où les composants conservent une fonction identique.

**Description détaillée d'au moins un mode de réalisation**

L'invention s'applique à une installation de refroidissement 2 améliorée pour une enveloppe électrique, par exemple une armoire électrique 1.

Selon l'invention, l'installation de refroidissement 2 comporte un circuit de refroidissement primaire C1 et un circuit de refroidissement secondaire C2 connecté au circuit de refroidissement primaire.

L'installation de refroidissement 2 comporte également un automate programmable 20 configuré pour commander le circuit de refroidissement primaire C1 et le circuit de refroidissement secondaire C2. Cet automate programmable 20 comporte classiquement un module de traitement, des modules d'entrée et des modules de sortie. Il peut également comporter un module de communication pour communiquer des données vers une unité centrale.

Le circuit de refroidissement primaire C1 comporte notamment les composants suivants :

- Un condenseur à air COND1 permettant de faire passer un fluide frigorigène FF1 de l'état gazeux à l'état liquide. Le condenseur à air COND1 peut être par exemple de type à tubes et ailettes ou à microcanaux.

- Un détendeur DET1 permettant de faire chuter la pression du fluide frigorigène FF1.

- Un premier évaporateur EV1 permettant de faire passer le fluide frigorigène FF de l'état gaz + liquide à l'état gazeux. L'évaporateur EV1 est destiné à être traversé par l'air à refroidir.

- Un ou plusieurs compresseurs COMP1 destiné à aspirer le fluide frigorigène FF1 à l'état gazeux en provenance de l'évaporateur EV1 pour l'envoyer vers le condenseur à air COND1.

- Plusieurs ventilateurs VENT10, VENT1 permettant d'assurer un passage d'air respectivement à travers le condenseur à air COND1 et à travers le premier évaporateur EV1.

- Eventuellement une ou plusieurs pompes de circulation.

- Des tuyaux de liaison entre les différents éléments du circuit.

Le circuit de refroidissement secondaire C2 comporte uniquement :

- Un deuxième évaporateur EV2.

- Une enceinte 5 isolée thermiquement dans laquelle est logé le deuxième évaporateur EV2 et qui comporte au moins une entrée d'air IN et une sortie d'air OUT à ouverture/fermeture commandée et connectée à des modules de sortie de l'automate programmable 20.

- Au moins un ventilateur VENT2 relié à un module de sortie de l'automate programmable 20, permettant de faire circuler l'air à refroidir entre l'entrée d'air et la sortie d'air lorsque celles-ci sont ouvertes.

- Au moins un tuyau d'entrée et un tuyau de sortie pour faire circuler le fluide frigorigène FF2 dans le circuit de refroidissement secondaire C2, relié sur l'entrée et la sortie du deuxième évaporateur et permettant au circuit de refroidissement secondaire de se raccorder au circuit de refroidissement primaire C1.

L'installation de refroidissement 2 peut comporter également un ensemble de capteurs de température reliés à des modules d'entrée de l'automate programmable, notamment :

- Un capteur de température pour mesurer la température ambiante T°amb à l'intérieur de l'armoire électrique 1 ;

Selon différents aspects particuliers de l'invention, les principes suivants peuvent être suivis :

- Le dimensionnement global de l'installation est réalisé en tenant compte de la puissance thermique maximale que les appareils électriques 3 présents dans l'armoire électrique 1 sont capables de dissiper et de leur cycle de fonctionnement.

- Le dimensionnement en puissance thermique à dissiper du deuxième évaporateur EV2 est supérieur à celui du compresseur COMP1. Autrement dit, la puissance thermique que le deuxième évaporateur EV2 peut dissiper est supérieure à celle pour laquelle le compresseur COMP1 est prévu, ce qui permet d'utiliser dans l'installation un compresseur qui est sous-dimensionné par rapport à l'ensemble de l'installation.

- Le dimensionnement du compresseur COMP1 (en puissance thermique donc en puissance électrique) dépend de la durée d'un cycle complet de charge du deuxième évaporateur EV2. Il faut en effet s'assurer que le deuxième évaporateur EV2 puisse être suffisamment chargé le plus rapidement possible, notamment lors d'un cycle de fonctionnement bas (c'est-à-dire lorsque T°amb<T°cons) le plus court possible (en durée). Dans cette dernière situation, le premier évaporateur EV1 n'est pas actif et toute la puissance du compresseur COMP1 est dédiée à la charge du deuxième évaporateur EV2.

- Le deuxième évaporateur EV2 doit être choisi avec une constante de temps tenant compte des conditions de fonctionnement de l'installation les plus extrêmes en température. En étant correctement dimensionné, le deuxième évaporateur doit pouvoir assurer une pointe de charge (c'est-à-dire une forte demande de dissipation) à tout instant. Cette constante de temps Sk s'exprime par la relation suivante :

$$Sk\_EV2 = (T°amb\_max - T°EV2)/(Pth\_EV2 + Pth\_EV1)$$

Dans laquelle :

- Sk_EV2 correspond à la constante de temps du deuxième évaporateur ;

- T°amb_max correspond à la température ambiante maximale que peut subir le volume interne de l'armoire électrique ;

- T°EV2 correspond à la température du deuxième évaporateur EV2 ;

A partir des données d'entrée reçues et en exécutant un programme de gestion de l'installation de refroidissement, l'automate programmable 20 détermine la puissance thermique Pth_D à dissiper dans l'armoire électrique.

Par ailleurs, l'automate progammable connaît avantageusement les données suivantes :

- La puissance thermique maximale Pth_EV1 que le premier évaporateur EV1 est capable dissiper ; Cette donnée peut être saisie en paramètre.

- La puissance thermique maximale Pth_EV2 que le deuxième évaporateur EV2 est capable de dissiper ; Cette donnée peut être saisie en paramètre ;

Il faut noter que l'automate programmable 20 peut également mettre en oeuvre des algorithmes de gestion connus tels que celui décrit dans la demande de brevet EP2759786A1. Ces algorithmes permettent de déterminer l'ensemble des données thermiques et électriques d'une installation de refroidissement à partir de mesures et de données d'état de fonctionnement des différents composants de l'installation.

L'automate programmable 20 est configuré pour exécuter un mode de fonctionnement parmi les deux modes de fonctionnement distincts suivants :

- Le premier mode de fonctionnement MOD1 est exécuté par l'automate programmable lorsque la puissance thermique à dissiper Pth_D dans l'armoire électrique 1 est inférieure ou égale à la puissance thermique Pth_EV1 que le premier évaporateur EV1 est capable de dissiper.

- Le deuxième mode de fonctionnement MOD2 est exécuté par l'automate programmable lorsque la puissance thermique à dissiper Pth_D dans l'armoire électrique 1 est strictement supérieure à la puissance thermique Pth_EV1 que le premier évaporateur EV1 est capable de dissiper.

Dans le premier mode de fonctionnement MOD1, comme le circuit de refroidissement primaire C1 est dimensionné pour fonctionner jusqu'à une puissance maximale, le surplus de puissance généré en fonctionnement (c'est-à-dire la puissance en surplus du compresseur COMP1 qui n'est pas utilisée par le premier évaporateur EV1) est employé pour charger en froid le second évaporateur EV2. Le circuit de refroidissement secondaire C2 est donc connecté au circuit de refroidissement primaire C1 pour utiliser l'énergie disponible dans le circuit de refroidissement primaire C1 pour charger son évaporateur EV2.

Dans le deuxième mode de fonctionnement MOD2, le premier évaporateur EV1 est insuffisant pour dissiper la puissance thermique Pth_D générée par les appareils 3 présents dans l'armoire électrique 1. Le circuit de refroidissement secondaire C2 est donc activé pour dissiper le surplus de puissance thermique que le premier évaporateur EV1 ne peut pas dissiper. Dans ce mode de fonctionnement, le deuxième évaporateur ne nécessite pas la puissance du compresseur. Le premier évaporateur EV1 est avantageusement utilisé au maximum de ses capacités.

L'installation de refroidissement 2 comporte ainsi des moyens de commutation, commandés par l'automate programmable 20 et connectés sur des modules de sortie. Ces moyens de commutation sont agencés pour assurer la commutation de l'installation entre le premier mode de fonctionnement MOD1 et le deuxième mode de fonctionnement MOD2. Ces moyens de commutation sont commandés par l'automate programmable 20 lorsque celui-ci sélectionne le premier mode de fonctionnement ou le deuxième mode de fonctionnement.

Dans le premier mode de fonctionnement MOD1, les moyens de commutation permettent de connecter le circuit de refroidissement secondaire C2 au circuit de refroidissement primaire C1. Le circuit de refroidissement primaire C1 est actif pour refroidir l'air présent dans l'armoire électrique et le circuit de refroidissement secondaire C2 est alors en mode charge. L'entrée d'air IN et la sortie d'air OUT de l'enceinte 5 qui renferme le second évaporateur EV2 sont alors commandés à la fermeture et le ventilateur VENT2 est inactif afin de stocker de l'énergie frigorifique dans le second évaporateur EV2.

Dans le deuxième mode de fonctionnement MOD2, les moyens de commutation permettent de déconnecter le circuit de refroidissement secondaire C2 du circuit de refroidissement primaire C1. L'entrée d'air IN et la sortie d'air OUT de l'enceinte 5 qui renferme le second évaporateur EV2 sont commandés à l'ouverture et le ventilateur VENT2 est actionné pour créer une circulation de l'air à refroidir au contact du second évaporateur EV2. Les deux circuits de refroidissement C1, C2 sont ainsi actifs.

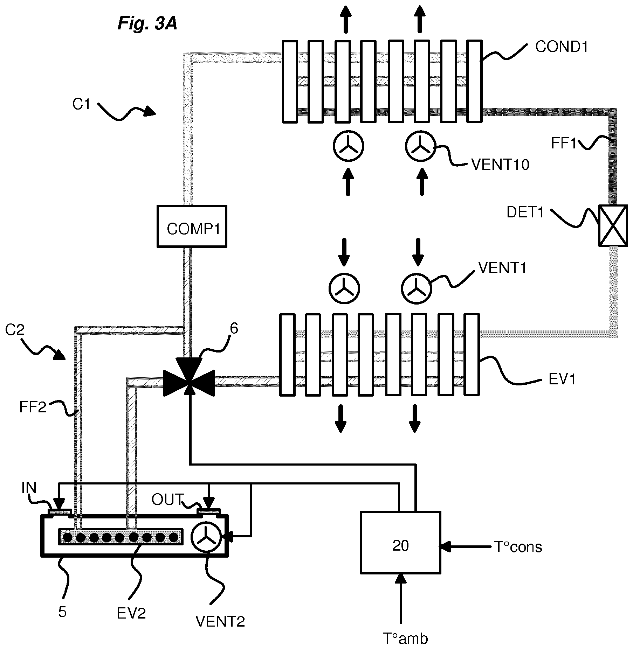

En référence à la figure 3A, dans un premier mode de réalisation, les moyens de commutation peuvent comporter une vanne 6 à trois voies pouvant prendre au moins les deux états suivants :

- Dans un premier état, elle permet de connecter le circuit de refroidissement secondaire C2 au circuit de refroidissement primaire C1, le second évaporateur EV2 est alors connecté en série avec le premier évaporateur EV1 ; Cet état est activé dans le premier mode de fonctionnement MOD1 de l'installation.

- Dans un deuxième état, elle permet de déconnecter le circuit de refroidissement secondaire C2 du circuit de refroidissement primaire C1; Cet état est activé dans le deuxième mode de fonctionnement MOD2 de l'installation.

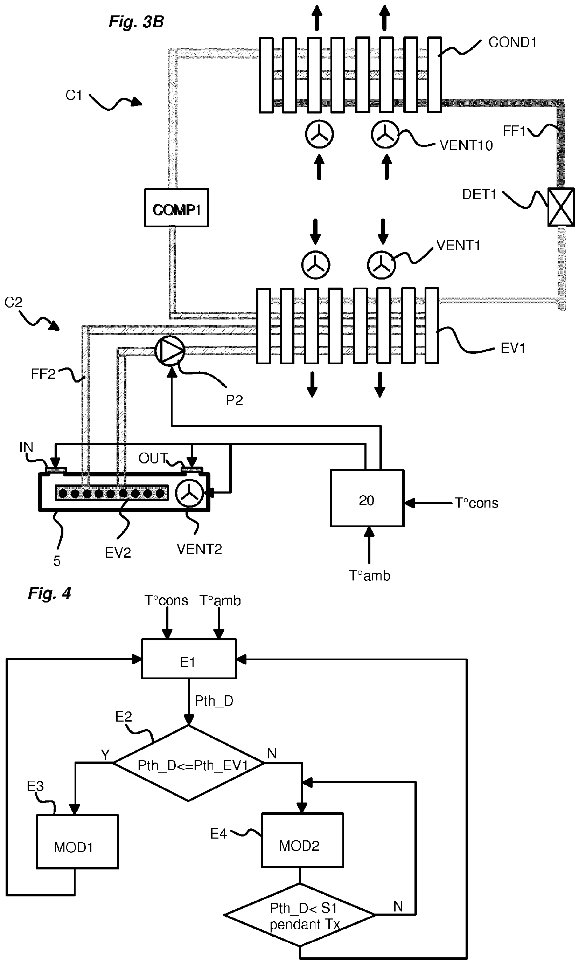

En référence à la figure 3B, dans un deuxième mode de réalisation, les moyens de commutation comportent une pompe P2. Le premier évaporateur EV1 du circuit de refroidissement primaire est alors de type hybride, c'est-à-dire qu'il comporte un premier circuit de refroidissement intégré au circuit de refroidissement primaire et un deuxième circuit de refroidissement, indépendant de son premier circuit de refroidissement, connecté sur le circuit de refroidissement secondaire et donc au second évaporateur EV2. La pompe P2 est positionnée sur le circuit de refroidissement secondaire C2. Dans le premier mode de fonctionnement MOD1, la pompe P2 est active, permettant ainsi de faire circuler le fluide frigorigène FF2 du premier évaporateur EV1 vers le deuxième évaporateur et ainsi d'emmagasiner de l'énergie frigorifique dans le second évaporateur EV2 lorsque la puissance thermique à dissiper dans l'armoire électrique est inférieure à la puissance thermique que le premier évaporateur EV1 est capable de dissiper. La pompe est désactivée dans le deuxième mode de fonctionnement MOD2 afin de déconnecter le circuit de refroidissement secondaire C2 du circuit de refroidissement primaire C1 et donc d'utiliser le circuit de refroidissement secondaire pour compléter le circuit de refroidissement primaire dans le refroidissement de l'air présent dans l'armoire électrique 1.

En référence à la figure 4, l'algorithme exécuté par l'automate programmable pour déterminer le mode de fonctionnement à appliquer est le suivant :

E1 : l'automate programmable reçoit une valeur de consigne T°cons en température à maintenir dans le volume interne de l'armoire électrique et une valeur mesurée de température T°amb mesurée à l'intérieur de l'armoire électrique. L'automate programmable compare la valeur de consigne à la valeur de température dans le volume interne de l'armoire électrique pour déterminer la puissance thermique Pth_D à dissiper dans l'armoire électrique.

E2 : En fonction de la puissance thermique à dissiper Pth_D déterminée, l'automate programmable 20 la compare à la puissance thermique Pth_EV1 maximale que le premier évaporateur EV1 est capable de dissiper. Cette puissance thermique Pth_EV1 est déterminée lors du dimensionnement du système, elle est saisie en tant que paramètre.

E3 : Si la puissance thermique à dissiper Pth_D est inférieure ou égale à la puissance thermique Pth_EV1 que le premier évaporateur EV1 est capable de dissiper, alors l'automate programmable sélectionne le premier mode de fonctionnement MOD1. L'air est donc refroidi par le premier évaporateur EV1 et le deuxième évaporateur EV2 est chargé avec le surplus d'énergie restant.

E4 : Si la puissance thermique à dissiper Pth_D est supérieure à la puissance thermique Pth_EV1 que le premier évaporateur EV1 est capable de dissiper, alors l'automate programmable sélectionne le deuxième mode de fonctionnement MOD2. L'air est donc refroidi par le premier évaporateur EV1 et par le deuxième évaporateur EV2 simultanément. L'enceinte 5 du deuxième évaporateur est ouverte et le ventilateur VENT2 est activé pour assurer une circulation d'air.

E5 : Le deuxième mode de fonctionnement MOD2 peut rester actif tant que la puissance thermique à dissiper Pth_D n'est pas redescendu en dessous d'une valeur seuil S1 pendant une durée déterminée Tx (par exemple 5 minutes).

Lorsque le deuxième mode de fonctionnement est sélectionné, l'algorithme peut également comporter une étape de vérification que le deuxième évaporateur EV2 présente une capacité de refroidissement suffisante pour combler les manques du premier évaporateur EV1. Il s'agit alors de comparer la puissance thermique Pth_EV2 que le deuxième évaporateur EV2 est capable de dissiper avec la différence entre la puissance thermique à dissiper Ph_D et la puissance thermique Pth_EV11 que le premier évaporateur est capable de dissiper. Si le deuxième évaporateur EV2 présente une capacité insuffisante, l'installation peut se placer en défaut et l'automate programmable 20 peut être amené à envoyer une commande d'arrêt des appareils électriques.

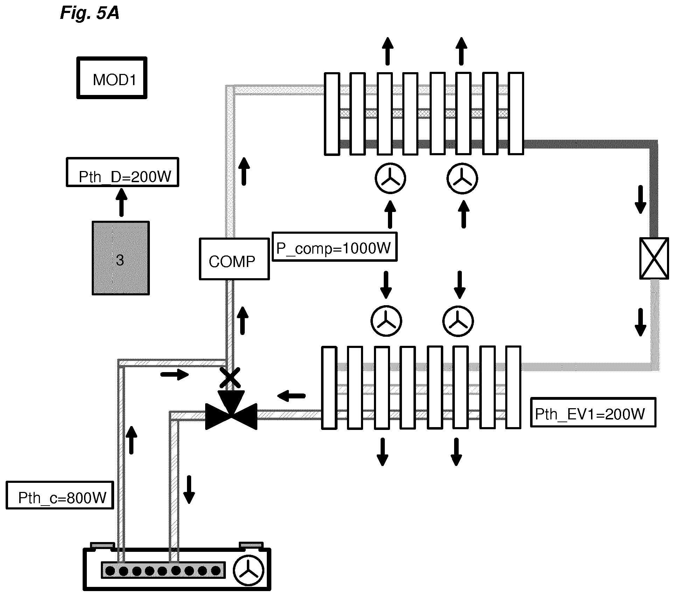

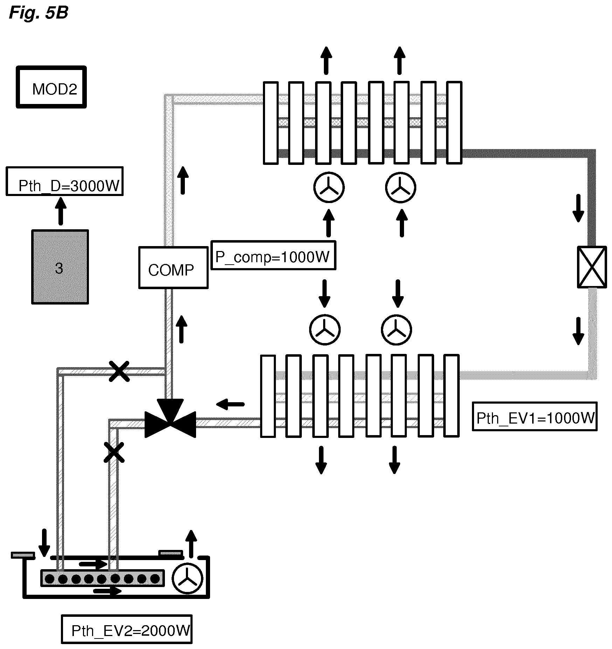

Les figures 5A et 5B illustrent, à partir du premier mode de réalisation décrit ci-dessus, le principe de fonctionnement de l'installation respectivement dans le premier mode de fonctionnement MOD1 et dans le deuxième mode de fonctionnement MOD2.

Sur la figure 5A, les appareils électriques 3 présents dans l'armoire électrique 1 génèrent une puissance thermique à dissiper Pth_D qui est égal à 200W. Le circuit de refroidissement primaire a la capacité de dissiper une puissance thermique de 1000W. Le premier évaporateur EV1 est donc amené à dissiper une puissance thermique Pth_EV1 de 200W tandis que les 800W restants sont utilisés pour charger le deuxième évaporateur. Sur la figure 5A, la vanne 6 est commandée de manière à connecter le circuit de refroidissement secondaire au circuit de refroidissement primaire. Le deuxième évaporateur EV2 se trouve alors connecté en série avec le premier évaporateur EV1. Le fluide frigorigène circule alors dans le premier évaporateur EV1 puis dans le deuxième évaporateur.

Sur la figure 5B, les appareils électriques 3 présents dans l'armoire électrique génèrent une puissance thermique à dissiper Pth_D qui est égal à 3000W. Le circuit de refroidissement primaire a la capacité de dissiper une puissance thermique de 1000W. Le premier évaporateur EV1 est donc amené à dissiper une puissance thermique de Pth_EV1 de 1000W. Le circuit de refroidissement secondaire C2 est activé pour dissiper les 2000W restants. Le deuxième évaporateur EV2 est ainsi amené à dissiper une puissance thermique Pth_EV2 de 2000W. Sur la figure 5B, la vanne 6 est commandée de manière à déconnecter le circuit de refroidissement secondaire du circuit de refroidissement primaire. Le deuxième évaporateur EV2 se trouve alors déconnecté du premier évaporateur EV1. L'entrée d'air IN et la sortie d'air OUT sont ouvertes. Le ventilateur VENT2 est activée pour permettre une circulation d'air à travers le deuxième évaporateur EV2.

On comprend de ce qui précède que la solution de l'invention présente de nombreux avantages, parmi lesquels :

- Elle permet de limiter la perte d'énergie lorsque l'installation est dans le premier mode de fonctionnement, le surplus d'énergie étant utilisé pour charger le deuxième évaporateur EV2 ;
- Elle permet de faire face aux pointes de charge, par l'utilisation du circuit de refroidissement secondaire ;
- Elle permet de pallier les défauts de fonctionnement ou les pannes du circuit de refroidissement primaire. Il est en effet toujours possible d'activer le circuit de refroidissement secondaire de manière indépendante pour refroidir l'air présent dans l'armoire électrique alors que le circuit de refroidissement primaire est inactif (pour différentes raisons volontaires ou involontaires) ;
- Elle est simple à mettre en oeuvre. Il suffit en effet de raccorder le circuit de refroidissement secondaire sur le circuit de refroidissement primaire et d'insérer les moyens de commutation adaptés.

## Revendications

1. Procédé de commande d'une installation de refroidissement du volume interne d'une enveloppe électrique, ladite installation de refroidissement comprenant :

   - Un circuit de refroidissement primaire (C1) qui comporte un condenseur (COND1), au moins un compresseur (COMP1) et un premier évaporateur (EV1),
   - Un circuit de refroidissement secondaire (C2) qui comporte une enceinte (5) isolée thermiquement, un second évaporateur (EV2) logé dans ladite enceinte (5) isolée thermiquement, une entrée d'air (IN) et une sortie d'air (OUT) à ouverture/fermeture commandée à travers ladite enceinte et un ventilateur (VENT2) agencé pour créer une circulation d'air entre ladite entrée d'air et ladite sortie d'air,
   - Un automate programmable (20) configuré pour sélectionner un mode de fonctionnement de l'installation de refroidissement parmi au moins un premier mode de fonctionnement (MOD1) dans lequel le circuit de refroidissement primaire (C1) est actif en refroidissement de l'air présent dans le volume interne, et le circuit de refroidissement secondaire (C2) est en charge en puissance frigorifique de son second évaporateur (EV2) et un deuxième mode de fonctionnement (MOD2) dans lequel le circuit de refroidissement primaire (C1) et le circuit de refroidissement secondaire (C2) sont actifs simultanément pour refroidir l'air présent dans ledit volume interne,
   - Ledit procédé comportant:

     - Une étape de sélection dudit mode de fonctionnement (MOD1) en tenant compte :

       - De la puissance thermique à dissiper (Pth_D) dans le volume interne de l'enveloppe électrique,
       - De la puissance thermique de refroidissement (Pth_EV1) du premier évaporateur (EV1),
       - Ledit premier mode de fonctionnement (MOD1) étant sélectionné par ledit automate programmable lorsque la puissance thermique à dissiper (Pth_D) dans l'armoire électrique est inférieure ou égale à la puissance thermique (Pth_EV1) que le premier évaporateur (EV1) est capable de dissiper,
       - Ledit deuxième mode de fonctionnement (MOD2) étant sélectionné par ledit automate programmable lorsque la puissance thermique à dissiper (Pth_D) dans l'armoire électrique est strictement supérieure à la puissance thermique (Pth_EV1) que le premier évaporateur (EV1) est capable de dissiper,

     - Une étape de commande par ledit automate programmable (20) de moyens de commutation adaptés pour commuter l'installation de refroidissement entre le premier mode de fonctionnement (MOD1) et le deuxième mode de fonctionnement (MOD2),
     - et en ce que, dans le premier mode de fonctionnement, l'étape de commande des moyens de commutation consiste à :

- Connecter le circuit de refroidissement secondaire au circuit de refroidissement primaire et à maintenir fermée ladite enceinte (5) isolée thermiquement, et en ce que, dans le deuxième mode de fonctionnement, l'étape de commande des moyens de commutation consiste à :
- Déconnecter le circuit de refroidissement secondaire du circuit de refroidissement primaire, à ouvrir l'entrée d'air et la sortie d'air et à activer le ventilateur (VENT2) pour entraîner une circulation d'air à travers l'enceinte (5) isolée thermiquement.

2. Procédé selon la revendication 1, **caractérisé en ce que** la puissance thermique à dissiper (Pth_D) est déterminée à partir de la différence entre une valeur de température de consigne (T°cons) et une valeur de température (T°amb) présente dans le volume interne de l'enveloppe électrique.

3. Procédé selon la revendication 1 ou 2, **caractérisé en ce que** la puissance thermique (Pth_EV1) que le premier évaporateur (EV1) est capable de dissiper est déterminée lors du dimensionnement de l'installation puis paramétré dans l'automate programmable (20).

4. Installation de refroidissement du volume interne d'une enveloppe électrique, ladite installation de refroidissement comprenant :

- l'enveloppe électrique ainsi que son volume interne, une enceinte (5) isolée thermiquement,
- Un circuit de refroidissement primaire (C1) qui comporte un condenseur (COND1), au moins un compresseur (COMP1) et un premier évaporateur (EV1),
- Un circuit de refroidissement secondaire (C2) qui comporte une enceinte (5) isolée thermiquement, un second évaporateur (EV2) logé dans ladite enceinte (5) isolée thermiquement, une entrée d'air (IN) et une sortie d'air (OUT) à ouverture/fermeture commandée à travers ladite enceinte et un ventilateur (VENT2) agencé pour créer une circulation d'air entre ladite entrée d'air et ladite sortie d'air,
- Un automate programmable (20) configuré pour sélectionner un mode de fonctionnement de l'installation de refroidissement parmi au moins un premier mode de fonctionnement (MOD1) dans lequel le circuit de refroidissement primaire (C1) est actif en refroidissement de l'air présent dans le volume interne, et le circuit de refroidissement secondaire (C2) est en charge en puissance frigorifique de son second évaporateur (EV2) et un deuxième mode de fonctionnement (MOD2) dans lequel le circuit de refroidissement primaire (C1) et le circuit de refroidissement secondaire (C2) sont actifs simultanément pour refroidir l'air présent dans ledit volume interne,
- L'automate programmable est configuré pour mettre en oeuvre le procédé de commande selon l'une des revendications 1 à 3.

5. Installation selon la revendication 4, **caractérisée en ce que** les moyens de commutation comportent une vanne trois voies aptes à prendre au moins deux états, un premier état dans lequel le circuit de refroidissement secondaire (C2) est connecté au circuit de refroidissement primaire (C1) dans le premier mode de fonctionnement (MOD1), et un deuxième état dans lequel le circuit de refroidissement secondaire (C2) est déconnecté du circuit de refroidissement primaire dans le deuxième mode de fonctionnement (MOD2).

6. Installation selon la revendication 4, **caractérisée en ce que** le premier évaporateur (EV1) est de type hybride comportant deux circuits de refroidissement indépendants, un premier circuit de refroidissement appartenant au circuit de refroidissement primaire (C1) et un deuxième circuit de refroidissement relié au circuit de refroidissement secondaire par l'intermédiaire d'une pompe (P2) incluse dans lesdits moyens de commutation.

7. Installation selon l'une des revendications 4 à 6, **caractérisée en ce que** la puissance thermique à dissiper (Pth_D) est déterminée à partir de la différence entre une valeur de température de consigne (T°cons) et une valeur de température (T°amb) présente dans le volume interne de l'enveloppe électrique.

8. Installation selon l'une des revendications 4 à 7, **caractérisée en ce que** le dimensionnement en puissance thermique à dissiper du deuxième évaporateur (EV2) est supérieur à celui du compresseur (COMP1).

9. Installation selon l'une des revendications 4 à 7, **caractérisée en ce que** la puissance thermique (Pth_EV1) que le premier évaporateur (EV1) est capable de dissiper est déterminée lors du dimensionnement puis paramétré dans l'automate programmable (20).

**Patentansprüche**

1. Verfahren zur Steuerung einer Kühlanlage des Innenvolumens einer elektrischen Umhüllung, wobei die Kühlanlage enthält:

   - einen Primärkühlkreis (C1), der einen Kondensator (COND1), mindestens einen Kompressor (COMP1) und einen ersten Verdampfer (EV1) aufweist,
   - einen Sekundärkühlkreis (C2), der ein wärmeisoliertes Gehäuse (5), einen im wärmeisolierten Gehäuse (5) untergebrachten zweiten Verdampfer (EV2), einen Lufteinlass (IN) und einen Luftauslass (OUT) mit gesteuertem Öffnen/Schließen quer durch das Gehäuse und ein Gebläse (VENT2) aufweist, das eingerichtet ist, um eine Luftzirkulation zwischen dem Lufteinlass und dem Luftauslass zu erzeugen,
   - einen programmierbaren Automaten (20), der konfiguriert ist, eine Betriebsart der Kühlanlage unter mindestens einer ersten Betriebsart (MOD1), bei der der Primärkühlkreis (C1) die im Innenvolumen vorhandenen Luft kühlend aktiv ist und der Sekundärkühlkreis (C2) seinen zweiten Verdampfer (EV2) mit Kälteleistung lädt, und einer zweiten Betriebsart (MOD2) auszuwählen, in der der Primärkühlkreis (C1) und der Sekundärkühlkreis (C2) gleichzeitig aktiv sind, um die im Innenvolumen vorhandene Luft zu kühlen,

   wobei das Verfahren aufweist:

   - einen Auswahlschritt der Betriebsart (MOD1) unter Berücksichtigung:

     - der in das Innenvolumen der elektrischen Umhüllung abzuleitenden Wärmeleistung (Pth_D),
     - der Kühlwärmeleistung (Pth_EV1) des ersten Verdampfers (EV1),
     - wobei die erste Betriebsart (MOD1) vom programmierbaren Automaten ausgewählt wird, wenn die in den Elektrogeräteschrank abzuleitende Wärmeleistung (Pth_D) niedriger als die oder gleich der Wärmeleistung (Pth_EV1) ist, die der erste Verdampfer (EV1) ableiten kann,
     - wobei die zweite Betriebsart (MOD2) vom programmierbaren Automaten ausgewählt wird, wenn die in den Elektrogeräteschrank abzuleitende Wärmeleistung (Pth_D) strikt höher ist als die Wärmeleistung (Pth_EV1), die der erste Verdampfer (EV1) ableiten kann,

   - einen Steuerschritt durch den programmierbaren Automaten (20) von Schalteinrichtungen, die geeignet sind, um die Kühlanlage zwischen der ersten Betriebsart (MOD1) und der zweiten Betriebsart (MOD2) umzuschalten, und dass in der ersten Betriebsart der Steuerschritt der Schalteinrichtungen darin besteht:
   - den Sekundärkühlkreis mit dem Primärkühlkreis zu verbinden und das wärmeisolierte Gehäuse (5) geschlossen zu halten,

   und dass in der zweiten Betriebsart der Steuerschritt der Schalteinrichtungen darin besteht:

   - den Sekundärkühlkreis vom Primärkühlkreis zu trennen, den Lufteinlass und den Luftauslass zu öffnen und das Gebläse (VENT2) zu aktivieren, um eine Luftzirkulation durch das wärmeisolierte Gehäuse (5) zu bewirken.

2. Verfahren nach Anspruch 1, **dadurch gekennzeichnet, dass** die abzuleitende Wärmeleistung (Pth_D) ausgehend von der Differenz zwischen einem Solltemperaturwert (T°cons) und einem Temperaturwert (T°amb) bestimmt wird, der im Innenvolumen der elektrischen Umhüllung vorhanden ist.

3. Verfahren nach Anspruch 1 oder 2, **dadurch gekennzeichnet, dass** die Wärmeleistung (Pth_EV1), die der erste Verdampfer (EV1) ableiten kann, bei der Dimensionierung der Anlage bestimmt und dann vom programmierbaren Automaten (20) parametriert wird.

4. Kühlanlage des Innenvolumens einer elektrischen Umhüllung, wobei die Kühlanlage enthält:

   - die elektrische Umhüllung sowie ihr Innenvolumen, ein wärmeisoliertes Gehäuse (5),
   - einen Primärkühlkreis (C1), der einen Kondensator (COND1), mindestens einen Kompressor (COMP1) und einen ersten Verdampfer (EV1) aufweist,
   - einen Sekundärkühlkreis (C2), der ein wärmeisoliertes Gehäuse (5), einen im wärmeisolierten Gehäuse (5) untergebrachten zweiten Verdampfer (EV2), einen Lufteinlass (IN) und einen Luftauslass (OUT) mit gesteuertem Öffnen/Schließen quer durch das Gehäuse und ein Gebläse (VENT2) aufweist, das eingerichtet ist, um eine Luftzirkulation zwischen dem Lufteinlass und dem Luftauslass zu erzeugen,

- einen programmierbaren Automaten (20), der konfiguriert ist, eine Betriebsart der Kühlanlage unter mindestens einer ersten Betriebsart (MOD1), in der der Primärkühlkreis (C1) die im Innenvolumen vorhandene Luft kühlend aktiv ist, und der Sekundärkühlkreis (C2) seinen zweiten Verdampfer (EV2) mit Kälteleistung lädt, und einer zweiten Betriebsart (MOD2) auszuwählen, in der der Primärkühlkreis (C1) und der Sekundärkühlkreis (C2) gleichzeitig aktiv sind, um die im Innenvolumen vorhandene Luft zu kühlen,
- der programmierbare Automat ist konfiguriert, um das Steuerverfahren nach einem der Ansprüche 1 bis 3 durchzuführen.

5. Anlage nach Anspruch 4, **dadurch gekennzeichnet, dass** die Schalteinrichtungen ein Dreiwegeventil aufweisen, das mindestens zwei Zustände annehmen kann, einen ersten Zustand, in dem der Sekundärkühlkreis (C2) in der ersten Betriebsart (MOD1) mit dem Primärkühlkreis (C1) verbunden ist, und einen zweiten Zustand, in dem der Sekundärkühlkreis (C2) in der zweiten Betriebsart (MOD2) vom Primärkühlkreis getrennt ist.

6. Anlage nach Anspruch 4, **dadurch gekennzeichnet, dass** der erste Verdampfer (EV1) vom Hybrid-Typ ist und zwei unabhängige Kühlkreise aufweist, einen ersten Kühlkreis, der zum Primärkühlkreis (C1) gehört, und einen zweiten Kühlkreis, der mit dem Sekundärkühlkreis mittels einer in den Schalteinrichtungen enthaltenen Pumpe (P2) verbunden ist.

7. Anlage nach einem der Ansprüche 4 bis 6, **dadurch gekennzeichnet, dass** die abzuleitende Wärmeleistung (Pth_D) ausgehend von der Differenz zwischen einem Solltemperaturwert (T°cons) und einem im Innenvolumen der elektrischen Umhüllung vorhandenen Temperaturwert (T°amb) bestimmt wird.

8. Anlage nach einem der Ansprüche 4 bis 7, **dadurch gekennzeichnet, dass** die Dimensionierung in abzuleitender Wärmeleistung des zweiten Verdampfers (EV2) größer ist als diejenige des Kompressors (COMP1).

9. Anlage nach einem der Ansprüche 4 bis 7, **dadurch gekennzeichnet, dass** die Wärmeleistung (Pth_EV1), die der erste Verdampfer (EV1) ableiten kann, bei der Dimensionierung bestimmt und dann im programmierbaren Automaten (20) parametriert wird.

## Claims

1. Method for controlling an installation for cooling the internal volume of an electrical enclosure, said cooling installation comprising:

   - a primary cooling circuit (C1), which comprises a condenser (COND1), at least one compressor (COMP1) and a first evaporator (EV1);
   - a secondary cooling circuit (C2), which comprises a thermally insulated chamber (5), a second evaporator (EV2) housed in said thermally insulated chamber (5), an air intake (IN) and an air outlet (OUT) with opening/closing that is controlled through said chamber and a fan (VENT2) arranged to create a circulation of air between said air intake and said air outlet;
   - a PLC (20) configured to select a mode for operating the cooling installation from at least one first operating mode (MOD1), in which the primary cooling circuit (C1) is active for cooling the air present in the internal volume and the secondary cooling circuit (C2) charges its second evaporator (EV2) with refrigeration power, and a second operating mode (MOD2), in which the primary cooling circuit (C1) and the secondary cooling circuit (C2) are simultaneously active in order to cool the air present in said internal volume;
   - said method comprising:

     - a step of selecting said operating mode (MOD1) taking into account:

       - the thermal power to be dissipated (Pth_D) in the internal volume of the electrical enclosure;
       - the thermal cooling power (Pth_EV1) of the first evaporator (EV1);
       - said first operating mode (MOD1) being selected by said PLC when the thermal power to be dissipated (Pth_D) in the electrical cabinet is less than or equal to the thermal power (Pth_EV1) that the first evaporator (EV1) is capable of dissipating;
       - said second operating mode (MOD2) being selected by said PLC when the thermal power to be dissipated (Pth_D) in the electrical cabinet is strictly greater than the thermal power (Pth_EV1) that the first evaporator (EV1) is capable of dissipating;

- a step of said PLC (20) controlling switching means adapted to switch the cooling installation between the first operating mode (MOD1) and the second operating mode (MOD2);
- and in that, in the first operating mode, the step of controlling the switching means consists in:
- connecting the secondary cooling circuit to the primary cooling circuit and keeping said thermally insulated chamber (5) closed, and in that, in the second operating mode, the step of controlling the switching means consists in:

- disconnecting the secondary cooling circuit from the primary cooling circuit, opening the air intake and the air outlet and activating the fan (VENT2) in order to cause air to circulate through the thermally insulated chamber (5).

2. Method according to Claim 1, **characterized in that** the thermal power to be dissipated (Pth_D) is determined on the basis of the difference between a setpoint temperature value (T°cons) and a temperature value (T°amb) present in the internal volume of the electrical enclosure.

3. Method according to either of Claims 1 and 2, **characterized in that** the thermal power (Pth_EV1) that the first evaporator (EV1) is capable of dissipating is determined when dimensioning the installation, then configured in the PLC (20).

4. Installation for cooling the internal volume of an electrical enclosure, said cooling installation comprising:

- the electrical enclosure and its internal volume, a thermally insulated chamber (5);
- a primary cooling circuit (C1), which comprises a condenser (COND1), at least one compressor (COMP1) and a first evaporator (EV1);
- a secondary cooling circuit (C2), which comprises a thermally insulated chamber (5), a second evaporator (EV2) housed in said thermally insulated chamber (5), an air intake (IN) and an air outlet (OUT) with opening/closing that is controlled through said chamber and a fan (VENT2) arranged to create a circulation of air between said air intake and said air outlet;
- a PLC (20) configured to select a mode for operating the cooling installation from at least one first operating mode (MOD1), in which the primary cooling circuit (C1) is active for cooling the air present in the internal volume and the secondary cooling circuit (C2) charges its second evaporator (EV2) with refrigeration power, and a second operating mode (MOD2), in which the primary cooling circuit (C1) and the secondary cooling circuit (C2) are simultaneously active in order to cool the air present in said internal volume;
- the PLC is configured to execute the control method according to any of Claims 1 to 3.

5. Installation according to Claim 4, **characterized in that** the switching means comprise a three-way valve capable of assuming at least two states, a first state, in which the secondary cooling circuit (C2) is connected to the primary cooling circuit (C1) in the first operating mode (MOD1), and a second state, in which the secondary cooling circuit (C2) is disconnected from the primary cooling circuit in the second operating mode (MOD2).

6. Installation according to Claim 4, **characterized in that** the first evaporator (EV1) is of the hybrid type comprising two independent cooling circuits, a first cooling circuit belonging to the primary cooling circuit (C1) and a second cooling circuit connected to the secondary cooling circuit by means of a pump (P2) included in said switching means.

7. Installation according to any of Claims 4 to 6, **characterized in that** the thermal power to be dissipated (Pth_D) is determined on the basis of the difference between a setpoint temperature value (T°cons) and a temperature value (T°amb) present in the internal volume of the electrical enclosure.

8. Installation according to any of Claims 4 to 7, **characterized in that** the dimensioning in terms of the thermal power to be dissipated from the second evaporator (EV2) is greater than that of the compressor (COMP1).

9. Installation according to any of Claims 4 to 7, **characterized in that** the thermal power (Pth_EV1) that the first evaporator (EV1) is capable of dissipating is determined during dimensioning, then configured in the PLC (20).

**Fig. 1**

**Fig. 2**

*Fig. 3A*

**Fig. 3B**

COND1, C1, VENT10, FF1, DET1, COMP1, VENT1, C2, EV1, FF2, P2, IN, OUT, 20, T°cons, T°amb, 5, EV2, VENT2

**Fig. 4**

T°cons  T°amb

E1

Pth_D

E2

Y — Pth_D<=Pth_EV1 — N

E3 — MOD1

E4 — MOD2

Pth_D< S1 pendant Tx — N

**Fig. 5A**

MOD1

Pth_D=200W

3

COMP

P_comp=1000W

Pth_EV1=200W

Pth_c=800W

**Fig. 5B**

MOD2

Pth_D=3000W

3

COMP

P_comp=1000W

Pth_EV1=1000W

Pth_EV2=2000W

**EP 3 584 514 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2013263611 A1

- EP 2759786 A1